(19) **Europäisches Patentamt / European Patent Office / Office européen des brevets**

(11) **EP 3 055 704 B1**

(12) **EUROPEAN PATENT SPECIFICATION**

(45) Date of publication and mention of the grant of the patent:
**05.12.2018 Bulletin 2018/49**

(21) Application number: **14851562.0**

(22) Date of filing: **07.10.2014**

(51) Int Cl.:
**G01R 23/165** ^(2006.01)

(86) International application number:
**PCT/IL2014/050881**

(87) International publication number:
**WO 2015/052713 (16.04.2015 Gazette 2015/15)**

(54) **ANALOG TO INFORMATION CONVERTER**

ANALOG-ZU-INFORMATION-WANDLER

CONVERTISSEUR D'INFORMATIONS ANALOGIQUES-NUMÉRIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.10.2013 IL 22877613**

(43) Date of publication of application:
**17.08.2016 Bulletin 2016/33**

(73) Proprietors:
• **Eim Distribution Ltd.**
 **4959376 Petach-Tikva (IL)**
• **Rabinovich, Roman**
 **4975001 Petah Tikva (IL)**

(72) Inventors:
• **RABINOVICH, Roman**
 **4975001 Petah Tikva (IL)**
• **OKLANDER, Boris**
 **1785012 Nazareth Illit (IL)**
• **ZVIRAN, Asaf**
 **5329517 Givatayim (IL)**

(74) Representative: **Lecomte & Partners**
 **P.O. Box 1623**
 **1016 Luxembourg (LU)**

(56) References cited:

| | |
|---|---|
| CN-A- 103 401 560 | GB-A- 2 189 631 |
| US-A- 3 855 423 | US-A1- 2008 024 336 |
| US-A1- 2008 024 336 | US-A1- 2009 222 226 |
| US-A1- 2011 149 791 | US-A1- 2011 149 791 |
| US-A1- 2014 198 836 | US-B1- 7 834 795 |

• **WEI-CHIEH HUANG ET AL: "An Efficient Spectrum-Sensing Method Based on Analog-to-Information Converter", VEHICULAR TECHNOLOGY CONFERENCE (VTC FALL), 2012 IEEE, IEEE, 3 September 2012 (2012-09-03), pages 1-5, XP032294634, DOI: 10.1109/VTCFALL.2012.6399059 ISBN: 978-1-4673-1880-8**
• **DUARTE, M. F. ET AL.: 'Structured compressed sensing: From theory to applications.' SIGNAL PROCESSING, IEEE TRANSACTIONS ON vol. 59, no. 9, 31 December 2011, pages 4053 - 4085, XP055332453 Retrieved from the Internet: <URL:http://webee.technion.ac.il/people/YoninaEldar/journals/121struct.pdf>**
• **TIAN Z. ET AL.: 'Compressed sensing for wideband cognitive radios.' ACOUSTICS, SPEECH AND SIGNAL PROCESSING, 2007. ICASSP 2007. IEEE INTERNATIONAL CONFERENCE ON vol. 4, 30 April 2007, page IV-1357, XP055332456 Retrieved from the Internet: <URL:http://www.ece.mtu.edu/faculty/ztian/papers/ cr_cssensing_icassp07.pdf>**
• **POLO, Y. L. ET AL.: 'Compressive wide-band spectrum sensing.' ACOUSTICS, SPEECH AND SIGNAL PROCESSING, 2009. 1 ICASSP 2009. IEEE INTERNATIONAL CONFERENCE ON 30 April 2009, pages 2337 - 2340, XP031459735 Retrieved from the Internet: <URL:http://cas.et.tudelft.nl/~leus/papers/icassp09_5.pdf>**

- **ELSNER, J. P . ET AL.: 'Compressed spectrum estimation for cognitive radios.' PROCEEDINGS OF 19TH VIRGINIA TECH SYMPOSIUM ON WIRELESS COMMUNICATIONS 30 June 2009, pages 1 - 4, XP055332460**

**Description**

**FIELD OF THE INVENTION**

This invention relates to signal processing and more particularly to a method of measuring signal features for RF signals within an ultra-wide frequency band-width.

**BACKGROUND OF THE INVENTION**

Spectrum sensing is a topical problem for many civilian and military applications, such as cognitive radio, real-time spectrum analyzer, electronic support measures (ESM) or radar warning receiver (RWR) applications. The main challenge in these fields is the capability to intercept, investigate and derive the features of complex RF signals in a wide frequency band-width. Most of the currently state-of the-art systems utilize down-conversion followed by sampling by analog-to-digital converter (ADC) and digital processing in the temporal and spectral domains. The main limitations arise from the band-width and bit depth of the ADC. The ADC is limited in sampling speed and hence in analysis band-width. These limitations were first described by *Nyquist-Shannon sampling theorem.* Practically, the abovementioned problem can be solved by combining multiple subsystems. Each subsystem provides down-conversion, sampling by the ADC and analysis of a separated frequency band. Evident drawbacks of this design are high weight-dimension and cost characteristics. Additionally, a memory storage problem arises, sampling the entire spectrum under the limitations of the *Nyquist-Shannon sampling theorem* cause an inflation of digital data to be stored and processed. In this situation, however, the information level of the signal is often far lower than the actual bandwidth, which prompt the development of more efficient sampling schemes such as analog-to-information. The current state-of-the-art methods of analog-to-information utilizes under-sampling (sampling in a lower frequency than the *Nyquist frequency*) with advanced signal processing and heuristics in order to recover the original signal features, these under-sampling methods are inherently noisy and the signal features are not always estimated accurately.

Furthermore, the simulation results illustrate that the proposed approach has improved performance in not only the MSE of average power estimation, but also in the detection probability.

Wei-Chieh Huang (IEEE, September 3, 2012, pages 1-5, XP032294634) discloses spectrum sensing for detecting channel occupancy. A power spectrum sensing method uses an analog-to-information converter (AIC). Power spectrum reconstruction is conducted before performing spectrum sensing. The developed AIC-based power spectrum sensing is capable of directly estimating the average power in each channel from the samples produced by AIC. The proposed method requires less computational operations because the reconstruction of power spectrum is not required.

US 20110149791 discloses a spectrum sensing scheme for a radio network which involves applying sensing in a distributed fashion to obtain an estimate of the signal spectrum. A network of the multiple sensing nodes (200-1 to 200-J) obtains such a spectrum estimate without requiring high-speed analog-to-digital converter to accommodate the large band-width of interest.

GB 2189631 discloses an RF spectrum analyzing receiver comprising front end RF filtering and amplifying stages for incoming signals, local oscillator generating means and mixing means whereby the incoming signals are mixed down to either zero IF or low IF frequency, digitizing means to which the mixed down signals are applied, and discrete Fourier transform means to which the digitized signals are applied to perform a frequency spectrum analysis of the signals.

US 3855423 discloses an apparatus for noise spectrum equalization of applied spectrum samples to enhance detection of periodic signals embedded in noise. Equalization is achieved with apparatus which repetitively searches for and detects strong periodic signals within the total signal spectrum and subsequently disregards the detected signals in computing an equalizing signal representative of background noise. The applied power spectrum is divided by the equalizing signal to obtain an equalized, flat, spectrum of zero mean, yet of unchanged signal levels relative to noise variance. The use of iterative detection of strong periodic signals in computing the equalizing signal results in noise spectrum equalization apparatus that is insensitive to the unwanted effects of strong periodic signals.

US 20080024336 discloses a long delay generator for the spectrum sensing of cognitive radio systems comprising of an Analog-to-Digital Converter (ADC), memory element, and Digital-to-Analog Converter (DAC). The memory element may utilize shift register bank or Random-Access Memory (RAM) cells. The long delay generator may provide for a selectable delay by digitizing the received signal, delaying the received signal in the digital domain, and reconstructing the delayed signal as an analog. The analog delayed signal may then be compared or otherwise correlated with the original input signal using an analog auto-correlation technique to determine whether a meaningful signal type has been identified or otherwise detected.

In summary, the known technologies are limited in their capability of simultaneous sampling of the whole spectral band of interest. Thus, there is a long-felt and unmet need to provide an analog-to-information converter capable to quickly recognize continuous and pulse RF signals within broad frequency band. Another need is the capability for filtering and discrimination between transmitters overlapping in time but transmitting at different frequencies.

## SUMMARY OF THE INVENTION

It is hence one object of the invention to disclose a method of spectral identification and feature extraction for RF signals in an ultra-wide bandwidth, according to claim 1. The aforesaid method comprises the steps of (a) obtaining said RF signal to be analyzed; (b) high-pass filtering of the obtained signal; (c) digitizing a compressed signal; and (d) analyzing digitized signal.

It is a core purpose of the invention to provide the method further comprising a step of spectrum compressing (SC) further comprising splitting said high pass filtered signal to two channels; Phase true-time delay modulating (shifting) said signal within one of said channels and mixing original and modulated signals.

The method further discloses the step of Phase true-time delay modulating comprising a linear modulation with sub-wavelength increments causes the Doppler frequency shift $f_d = \frac{v}{c} \cdot F_c$, where $v$ is the velocity of the linear range modulation defined by digitally controlled switching circuit, c is the speed of light, $f_d$ is the Doppler shift and $F_c$ is the carrier frequency.

A further object of the invention is to disclose the step of SC comprising linearly mapping high-frequency spectrum within low frequency spectrum band.

A further object of the invention is to disclose the step of analyzing digitized signal comprising Fast Fourier Transform.

A further object of the invention is to disclose an analog-to information converter of an RF signal according to claim 5. The aforesaid converter comprises: (a) spectrum compression unit; (b) a digitizer of an obtained compressed signal; and (c) a digital signal processing unit.

It is a core purpose of the invention to provide the spectrum compression unit further comprising a splitter configured to split a high pass filtered signal to two channels, phase true-time delay line disposed in one of said channels, a mixing unit configured for mixing signals downstream of said channels and a low-pass filter configured for filtering a mixed signal.

Additional object of the invention is to present an optimized implementation for the Analog-to-Information converter, utilizing linear spectrum compression (LSC) implementation. The linear Analog-to-information implementation further comprises a splitter configured to split a high pass filtered signal to two channels, phase true-time delay disposed in one of said channels and two digitizers (analog-to-digital converters) for the sampling of each RF channel separately.

A further object of the invention is to disclose digital signal processing unit which comprises_Fast Fourier Transformation for each separate digitized channel and an algorithmic processing for the cross-detection of original and modulated frequencies and the extraction of accurate spectral and temporal signal features.

Additional object of the invention is to present a method to derive spectrum compression by completely digital design, utilizing digital spectrum compression (DSC). The digital Analog-to-information implementation according to claim 7 further comprises a splitter configured to split a high pass filtered signal to two channels, followed by two digitizers (analog-to-digital converters) for the sampling of each RF channel separately and a specific digital Doppler processing unit.

A further object of the invention is to disclose digital signal processing unit which generate accurate Doppler-shift in a fully digitally controlled manner. This digital Doppler generator (DDG) processing is characterized by predetermined sampling rates, a decimation procedure, Fast Fourier Transformation and a predetermined normalization of the frequency spectrum.

A further object of the invention is to disclose the converter configured for at least one application selected from the group consisting of; (a) Ultra wide band-width real-time spectrum, (b) Spectrum sensing and management for cognitive radio, (c) Emitter identification and mapping for ESM systems and (d) Ultra wide band-width RWR systems.

## BRIEF DESCRIPTION OF THE DRAWINGS

In order to understand the invention and to see how it may be implemented in practice, a plurality of embodiments is adapted to now be described, by way of non-limiting example only, with reference to the accompanying drawings, in which

Fig. 1 is a flowchart of a method of identifying a spectrum and extracting spectrum features;

Fig. 2 is a flowchart of an optimized method of linear spectrum compression;

Fig. 3 is a schematic diagram of a linear analog-to-information converter; and

Fig. 4 is a schematic diagram of a digital analog-to-information converter.

**DETAILED DESCRIPTION OF THE INVENTION**

The following description is provided, so as to enable any person skilled in the art to make use of said invention and sets forth the best modes contemplated by the inventor of carrying out this invention. Various modifications, however, are adapted to remain apparent to those skilled in the art, since the generic principles of the present invention have been defined specifically to provide a method of analyzing spectral characteristic of an RF signal and an apparatus for implementation thereof.

Concurrently mapping transmitters within the whole RF spectrum from 100 MHz to 18 GHz is at present a very relevant task. A solution of this task is primarily limited by the capability of concurrent spectral sampling.

In accordance with the present invention, the spectral band is compressed such that spectral characteristics and spatial layout of the transmitters are kept intact.

The present invention provides a recognition capability of continuous and burst RF signals at a broad frequency bandwidth. Additionally, an analog-to-information converter of the present invention is able to discriminate time overlapping transmitters with different spectral characteristics.

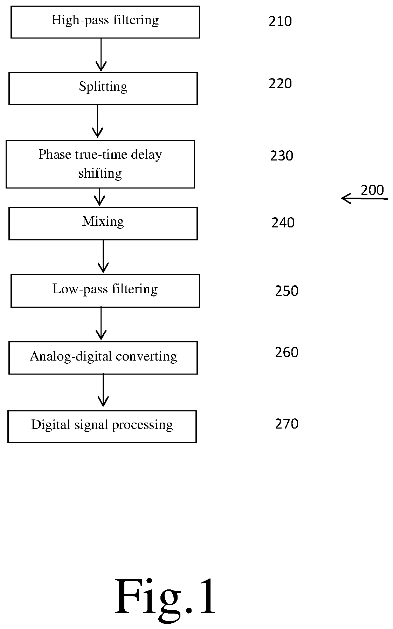

Reference is now made to Fig. 1, presenting a flowchart of a method 200 of identifying a transmitter and extracting spectrum features. In accordance with an exemplar embodiment of the present invention, and obtained signal is high-pass filtered at a step 210. Then, a high-pass filtered signal is split to two channels (step 220). One of the channels is provided with phase true-time delay shifter. Step 230 refers to inserting phase true-time delay to high frequency signal. Original and modulated signals are mixed at a step 240. After that, the obtained mixed signal is low-pass filtered at a step 250 and digitized at a step 260 (analog-digital conversion). An obtained digital signal is processed to identify the transmitter and extract its features at a step 270. In accordance with one embodiment of the present invention, Fast Fourier Transform is used for processing the obtained digital signal.

The present spectrum compression (SC) method can be characterized by the following formulas:
Integration time is given by

$$Int\_time = \frac{2^{TTD\_bit}}{TTD\_switching\_rate} = \frac{1}{Dopp\_res}$$

where

$TTD\_bit$ is a number of bits decoding the binary choice of physical delays. The phase true-time delay has $2^{TTD\_bit}$ optional delays.
$Dopp\_res$ is Doppler frequency resolution;
$TTD\_switching\_rate$ is a rate of switching between different values of delays and determines the speed enforced on the signal

Speed indicating a number of switching between different values of delay per time which creates the Doppler frequency is given by

$$V = \frac{TTD\_span}{Int\_time},$$

where

$TTD\_span$ is the largest range delay that can be chosen in the Phase true-time delay.
$Freq\_span$ is the maximal carrier frequency band-width that can be measured and/or compressed by the system, according to Nyquist sampling frequency

$$Freq\_span = \frac{c \cdot Doppler\_span}{V} = \frac{c \cdot 2^{TTD\_bit}}{TTD\_span} = \frac{c}{TTD\_Res}$$

where

Dopp_span is the maximal Doppler frequency band-width that can be measured by the system, according to Nyquist sampling frequency; and
c is the light speed.

Freq_res is the minimum carrier Frequency difference between two RF signals that allows discrimination between the signals, or equivalently the resolution of the FFT representation of the carrier frequency.

$$Freq\_res = \frac{c}{TTD\_span} = \frac{c}{Int\_time * V}$$

where

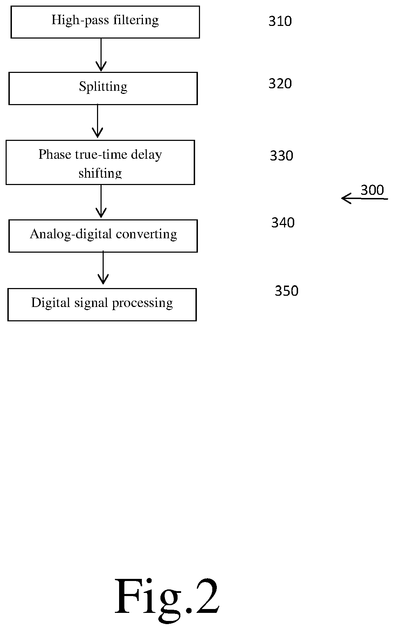

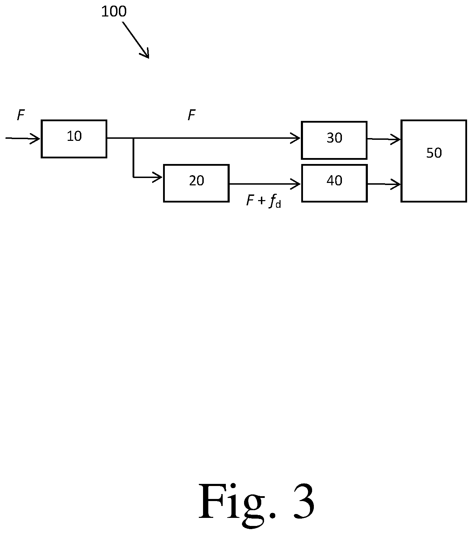

TTD_res is the smallest range delay that can be chosen in the Phase true-time delay, and also the difference between any two consecutive delays (the delay increment of each switching event) during the linear delay modulation.
In order to overcome the limitation of mixer nonlinearity and the limiting relation between TTD_span and the measured Frequency resolution, we further present an optimized linear spectrum compression (LSC) implementation.
Reference is now made to Fig. 2, presenting a flowchart of an optimized method of linear spectrum compression 300. In accordance with an exemplar embodiment of the present invention, an obtained signal is high-pass filtered at a step 310. Then, a high-pass filtered signal is split to two channels (step 320). One of the channels is provided with phase true-time delay shifter. Step 330 refers to inserting phase true-time delay to high frequency signal. Original and modulated signals are digitized separately at a step 340 (analog-digital conversion). The two obtained digital signals are then processed to identify the transmitter and extract their features at a step 350. In accordance with one embodiment of the present invention, Fast Fourier Transform is used for the processing of the two obtained digital signals, followed by an algorithmic processing for the cross-detection and association of original and modulated frequencies and the extraction of accurate spectral and temporal signal features. It should be noted that the presented implementation supplies two sources of frequency information which can be fused together for the calculation of accurate and ambiguity-free frequency measurement. The first source of frequency information is the Doppler shift between modulated and original frequencies which allows for calculation of ambiguity-free frequency measurement with Mhz scale resolution (according to the Freq_res equation). The second source of frequency information is under-sampled measurement of the original frequency which being combined with the Doppler shift allows for calculation of ambiguity-free frequency measurement with Khz scale resolution.
Reference is now made to Fig. 3 presenting a schematic diagram of an analog-to-information converter 100 comprising a high-pass filter 10, a phase true-time delay unit 20, two analog-to-digital converters 30 and 40 and a digital signal processing unit 50.
A signal from a source (antenna or other) is high-pass filtered in the high-pass filter 10. Then, the filtered signal is split into two channels. One of the channels is provided with a phase true-time delay unit 20 which is able to insert a linear delay modulation (interpreted as a Doppler shift) defined as

$$f_d = \frac{v}{c} \cdot F_c = K \cdot F_c,$$

where v is the velocity of the linear range modulation, c is the speed of light, $f_d$ is the doppler shift and $F_c$ is the carrier frequency.
The variable v is computer-controlled according to a switching rate between different values of physical delay. The aforesaid delay is implemented by means of dynamically controlled switch between RF or optical delay lines. The inserted delay shift is about several mm for each switching event.
Thus, a linear mapping from a carrier frequency ($F_c$) to a low Doppler frequency ($f_d$) is implemented. The parameter K explicitly expresses a compression ratio between the original spectrum (GHz) and a compressed spectrum (MHz) obtained by means of phase true-time delay modulation. It should be emphasized that the aforesaid conversion keeps spectral distances between transmitters, general and internal structures of transmitter waveform.
Signals $F_c$ and $F_c + f_d$ from the two channels are then digitized separately in the analog-to-digital converters 30 and 40, the two digitized signals are analyzed in the digital signal processing unit 50.
Alternatively, the linear spectrum compression (LSC) can be implemented in a completely digital design which renders the phase true-time delay unit (unit 20) unnecessary. For this purpose, we further present a digital spectrum compression (DSC) implementation.

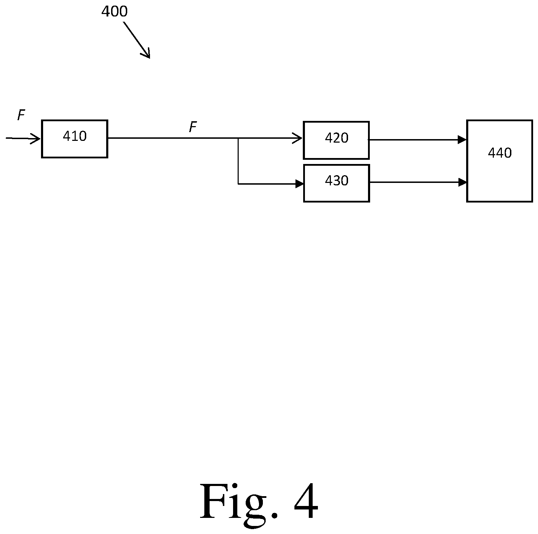

Reference is now made to Fig. 4 presenting a schematic diagram of a digital analog-to-information converter 400 comprising a high-pass filter 410, two analog-to-digital converters 420 and 430 and a digital signal processing unit 440.

A signal from a source (antenna or other) is high-pass filtered in the high-pass filter 410. Then, the filtered signal is split into two channels where the two channels are digitized separately in the analog-to-digital converters 420 and 430. The sampling rate at unit 420 and 430 will be defined as $f_1$ and $f_2$, respectively. The relation between the sampling rates at the two analog-to-digital converters is defined as

$$f_2 = f_1 \cdot (1 + K)^{-1} = f_1 \cdot \frac{c}{c + v}$$

where v is the desired Doppler velocity, c is the speed of light, K is the compression ratio, and $f_1$, $f_2$ are the sampling rates in unit 420 and 430, respectively.

The two digitized signals generated at unit 420 and 430 will be defined as $Y_1$ and $Y_2$, respectively. These digital signals are than analyzed in the digital signal processing unit 440.

A further object of the invention is to disclose the digital signal processing at unit 440 which configured for decimation of $Y_1$ to equal length as $Y_2$, Fast Fourier Transform for each separate digitized channel ($F(Y_1)$ and $F(Y_2)$), and normalization of the frequency spectrum of $Y_2$ by the following relation: $F(Y_2)*(1+K)$.

We claim that the proposed digital spectrum compression (DSC) implementation is equivalent to the analog Doppler shift method characterized at the linear spectrum compression (**LSC**). The basis for this claim relies on the mathematical equivalence of the following relations

Define the digitized signal generated from the analog phase true-time delay unit 20 and analog-to-digital converter 40 as $W_1$, then

$$W_1[n] = \sin\left(2\pi F \cdot [1 + K] \cdot \frac{n}{f_1}\right) = \sin\left(2\pi F \cdot \frac{n}{f_2}\right) = Y_2[n]$$

where $F$ is input signal frequency, K is the compression ratio, n is the digital sample index, $f_1$ is the sampling rate at the **LSC** system implementation and $f_2 = f_1 \cdot (1+K)^{-1}$ is the required sampling rate in unit 430 at the **DSC** implementation. For this sampling rate, the frequency of the under-sampled (aliased) signal generated by Fast Fourier Transform on $Y_2$ can be represented by

$$F(Y_2) = F - N \cdot f_2 = F - N \cdot f_1 \cdot (1 + K)^{-1}$$

where N is the closest replicate of $f_2$ to F, meaning that $N = \arg \min_N (F - N \cdot f_2)$.

Therefore, after normalization of the frequency spectrum by $F(Y_2)*(1+K)$, we get

$$F(Y_2) \cdot (1 + K) = F \cdot (1 + K) - N \cdot f_1 = F(W_1)$$

Meaning that there is equivalency between the spectrum mapping generated by the analog phase true-time delay unit 20 and analog-to-digital converter 40 defined as $F(W_1)$ and between the spectrum mapping generated by sampling at rate $f_2$ at unit 430 and executing the suggested digital processing on $Y_2$.

Various applications such as Ultra wide band-width real-time spectrum, Spectrum sensing and management for cognitive radio, Emitter identification and mapping for ESM systems, Ultra wide band-width RWR systems are in the scope of the present invention.

**Claims**

1. A method of identifying a spectrum and extracting features thereof for RF signals in an ultra-wide bandwidth; said method comprising the steps of

   a. obtaining said RF signal to be analyzed;

*b.* high-pass filtering said obtained signal;
c. *digitizing* said high filtered signal;
d. spectrum compressing SC;
e. analyzing said digitized signal;

**characterized in that** said step of spectrum compressing SC further comprises splitting said high pass filtered signal into two channels; *Phase true-time delay* modulating said signal within one of said channels; said step of Phase true-time delay modulating comprises a linear modulation with sub-wavelength increments causing the Doppler frequency shift $f_d = \frac{v}{c} \cdot F_c$, where *v* is the velocity of the linear range modulation defined by digitally controlled switching circuit, c is the speed of light, $f_d$ is the Doppler shift and $F_c$ is the carrier frequency;

said *step of* SC comprises linearly mapping high-frequency spectrum within low frequency spectrum;

said step of analyzing said digital signal comprises fusing spectral information derived from under-sampled measurement of the original frequency and the Doppler shift between original and modulated frequencies enabling calculation of ambiguity-free frequency measurement with Khz scale frequency resolution.

2. The method according to claims 1, **characterized in that** said step of digitizing said high filtered signal comprises digitizing the original high filtered signal, the compressed signal and/or the modulated signal.

3. The method according to claims 1 comprising a step of mixing said original and modulated signals.

4. The method according to claim 1 configured for at least one application selected from the group consisting of;

   a. Ultra wide band-width real-time spectrum;
   b. Spectrum sensing and management for cognitive radio;
   c. Emitter identification and mapping for ESM systems; and
   d. Ultra wide band-width RWR systems.

5. A linear analog-to-information converter of an RF signal: said converter comprising:

   a. a linear spectrum compression LSC unit;
   b. two digitizers configured for sampling obtained original and modulated signals;
   c. a digital signal processing unit;

   **characterized in that** said LSC unit further comprises a splitter configured to split a high pass filtered signal to two channels, phase true-time delay line disposed in one of said channels.

6. The converter according to claim 5, **characterized in that** said digital signal processing unit comprises Fast Fourier Transform for the processing said digital signals, followed by an algorithmic processing for the cross-detection and association of original and modulated frequencies and the extraction of accurate spectral and temporal signal features.

7. A digital analog-to-information converter of an RF signal, said converter comprising:

   a. a splitter configured to split the high pass filtered signal into two channels, followed by
   b. a first digitizer and a second digitizer, configured for sampling the obtained signals at two specifically tuned sampling rates;
   c. a digital signal processing unit;

   **characterized in that** said digital signal processing unit is configured for digital Doppler generator processing through predetermined sampling rates, a decimation procedure, Fast Fourier Transformation and a predetermined normalization of the frequency spectrum.

8. The digital analog-to information converter according to claim 7, wherein a relation between the sampling rates at said first and second digitizers is given by:

$$f_2 = f_1 \cdot \left(1 + K\right)^{-1} = f_1 \cdot \frac{c}{c + v}$$

where v is the desired Doppler velocity, c is the speed of light, K is the compression ratio, and $f_1$, $f_2$ are the sampling rates.

9. The digital analog-to information converter according to claim 7, **characterized in that** said digital signal processing unit is configured for decimation of signal $Y_1$ digitized by said first digitizer to equal length as signal $Y_2$ digitized by said second digitizer, Fast Fourier Transforms thereof ($F(Y_1)$ and $F(Y_2)$), and normalization of the frequency spectrum of $Y_2$ by the following relation:

$$F(Y_2)*(1+K).$$

10. The converter according to claims 7 configured for at least one application selected from the group consisting of;

   e. Ultra wide band-width real-time spectrum;
   f. Spectrum sensing and management for cognitive radio;
   g. Emitter identification and mapping for ESM systems; and
   h. Ultra wide band-width RWR systems.

**Patentansprüche**

1. Ein Verfahren zum Identifizieren eines Spektrums und zum Extrahieren von Merkmalen davon für HF-Signale in einer ultrabreiten Bandbreite; wobei das Verfahren die Schritte umfasst

   a. Erhalten des zu analysierenden HF-Signals;
   b. Hochpassfiltern des erhaltenen Signals;
   c. Digitalisieren des hochpassgefilterten Signals;
   d. Spektrum Kompression SC;
   e. Analysieren des digitalisierten Signals;

   **dadurch gekennzeichnet, dass** der Schritt des Spektrumskomprimierens SC ferner umfasst: Aufteilen des hochpassgefilterten Signals in zwei Kanäle; Phasen-Echtzeitverzögerung Modulierung des Signals in einem der Kanäle; der Schritt der Phasen-Echtzeitverzögerungsmodulation umfasst eine lineare Modulation mit Subwellenlängeninkrementen, die die Dopplerfrequenzverschiebung $f_d = \frac{v}{c} \cdot F_c$ verursachen, wobei v die Geschwindigkeit der linearen Bereichsmodulation ist, die durch die digital gesteuerte Umschaltschaltung definiert ist, c ist die Lichtgeschwindigkeit, $f_d$ ist die Dopplerverschiebung und Fc ist die Trägerfrequenz; der Schritt von SC umfasst das lineare Abbilden des Hochfrequenzspektrums innerhalb eines Niederfrequenzspektrums; der Schritt des Analysierens des digitalen Signals umfasst Fusing der spektralen Information, die aus der unterabgetasteten Messung der ursprünglichen Frequenz und der Dopplerverschiebung zwischen ursprünglichen und modulierten Frequenzen abgeleitet wird, wodurch die Berechnung einer mehrdeutigkeitsfreien Frequenzmessung mit einer Khz-Skalenfrequenzauflösung ermöglicht wird.

2. Verfahren nach Anspruch 1, **dadurch gekennzeichnet, dass** der Schritt des Digitalisierens des hochpassgefilterten Signals das Digitalisieren des ursprünglichen hochpassgefilterten Signals, des komprimierten Signals und/oder des modulierten Signals umfasst.

3. Verfahren nach Anspruch 1, umfassend einen Schritt des Mischens der ursprünglichen und modulierten Signale.

4. Verfahren nach Anspruch 1, konfiguriert für mindestens eine Anwendung ausgewählt aus der Gruppe bestehend aus;

   a. ein. Ultrabreitband-Echtzeitspektrum;

b. Spektrumserfassung und -management für kognitives Radio;
c. Emitteridentifikation und -kartierung für ESM-Systeme; und
d. Ultrabreitband-RWR-Systeme.

5. Linearer Analog-zu-Information-Wandler eines HF-Signals: der Wandler umfasst:

   a. ein. eine lineare spektrale Kompressions-LSC-Einheit;
   b. zwei Digitalisierer, zum Abtasten der erhalten ursprünglichen und modulierte Signale konfiguriert ist;
   c. eine digitale Signalverarbeitungseinheit;

   **dadurch gekennzeichnet, dass** die LSC-Einheit ferner einen Splitter umfasst, der konfiguriert ist, um ein hochpassgefiltertes Signal auf zwei Kanäle aufzuteilen, eine Phasen-Echtzeitverzögerungsleitung, die in einem der Kanäle angeordnet ist.

6. Wandler nach Anspruch 5, **dadurch gekennzeichnet, daß** die digitale Signalverarbeitungseinheit eine schnelle Fourier-Transformation für die Verarbeitung der digitalen Signale aufweist, gefolgt von einer algorithmischen Verarbeitung für die Kreuzdetektion und Zuordnung von ursprünglichen und modulierten Frequenzen und die Extraktion von genauen spektrale und zeitliche Signalmerkmale.

7. Digitaler Analog-zu-Information-Wandler eines HF-Signals, wobei der Wandler umfasst:

   a. ein Splitter, der konfiguriert ist, das hochpassgefilterte Signal in zwei Kanäle aufzuteilen, gefolgt von
   b. einen ersten Digitalisierer und einen zweiten Digitalisierer, die zum Abtasten der erhaltenen Signale mit zwei speziell abgestimmten Abtastraten konfiguriert sind;
   c. eine digitale Signalverarbeitungseinheit;

   **dadurch gekennzeichnet, dass** die digitale Signalverarbeitungseinheit für eine digitale Doppler-Generator-Verarbeitung über vorbestimmte Abtastraten, eine Dezimierungsprozedur, eine schnelle Fourier-Transformation und eine vorbestimmte Normalisierung des Frequenzspektrums konfiguriert ist.

8. Digitaler Analog-zu-Information-Wandler nach Anspruch 7, wobei eine Beziehung zwischen den Abtastraten bei den ersten und zweiten Digitalisierern gegeben ist durch:

$$f_2 = f_1 \cdot \left(1 + K\right)^{-1} = f_1 \cdot \frac{c}{c + v}$$

wobei v die gewünschte Dopplergeschwindigkeit ist, c ist die Lichtgeschwindigkeit, K ist das Kompressionsverhältnis und $f_1$, $f_2$ sind die Abtastraten.

9. Digitaler Analog-zu-Information-Wandler nach Anspruch 7, **dadurch gekennzeichnet, dass** die Digitalsignalverarbeitungseinheit zur Dezimierung des von dem ersten Digitalisierer digitalisierten Signals $Y_1$ auf gleiche Länge wie das von dem zweiten Digitalisierer digitalisierte Signal $Y_2$, schnelle Fourier Transformation ($F(Y_1)$ und $F(Y_2)$) und Normierung des Frequenzspektrums von Y2 durch die folgende Beziehung:

$$F(Y_2) * (1 + K).$$

10. Wandler nach Anspruch 7, konfiguriert für mindestens eine Anwendung ausgewählt aus der Gruppe bestehend aus;

   e. Ultrabreitband-Echtzeitspektrum;
   f. Spektrumserfassung und -management für kognitives Radio;
   g. Emitter-Identifikation und Datenzuordnung für ESM-Systeme; und
   h. Ultrabreitband-RWR-Systeme.

**Revendications**

1. Procédé d'identification d'un spectre et d'extraction de ses caractéristiques pour des signaux RF dans une bande passante ultra large; ledit procédé comprenant les étapes consistant à

   a. obtenir ledit signal RF à analyser;
   b. filtrage passe-haut dudit signal obtenu;
   c. numériser ledit signal filtré élevé;
   d. compression du spectre SC;
   e. analyser ledit signal numérisé;

   **caractérisé en ce que** ladite étape de compression de spectre SC comprend, en outre, diviser ledit signal filtré passe-haut en deux canaux; moduler en retard de phase en temps réel ledit signal dans l'un desdits canaux; ladite étape de modulation en retard de phase en temps réel comprend une modulation linéaire avec des incréments de sous-longueur d'onde provoquant le décalage de fréquence Doppler $f_d = \frac{v}{c} \cdot F_c$, où v est la vitesse de la modulation linéaire définie par un circuit de commutation commandé numériquement, c la vitesse de la lumière, $f_d$ est le décalage Doppler et $F_c$ est la fréquence porteuse;
   ladite étape SC comprend l'action de cartographier de manière linéaire le spectre haute fréquence dans un spectre basse fréquence;
   ladite étape d'analyse dudit signal numérique comprend fusionner des informations spectrales dérivées d'une mesure sous-échantillonnée de la fréquence d'origine et du décalage Doppler entre des fréquences originales et modulées, permettant le calcul d'une mesure de fréquence sans ambiguïté avec une résolution de fréquence à l'échelle du Khz.

2. Procédé selon la revendication 1, **caractérisé en ce que** ladite étape de numérisation dudit signal filtré haut comprend la numérisation du signal filtré haut d'origine, du signal compressé et/ou du signal modulé.

3. Procédé selon la revendication 1, comprenant une étape consistant à mélanger lesdits signaux originaux et modulés.

4. Procédé selon la revendication 1, configuré pour au moins une application sélectionnée dans le groupe consistant en;

   a. Spectre temps réel de bande passante ultra large;
   b. Détection et gestion du spectre pour la radio cognitive;
   c. Identification et cartographie des émetteurs pour les systèmes ESM; et
   d. Systèmes RWR à très large bande passante.

5. Convertisseur linéaire analogique-information d'un signal RF: ledit convertisseur comprenant:

   a. une. une unité LSC de compression à spectre linéaire;
   b. deux numériseurs configurés pour échantillonner les signaux originaux et modulés obtenus;
   c. une unité de traitement de signal numérique;

   **caractérisé en ce que** ladite unité LSC comprend en outre un séparateur configuré pour séparer un signal filtré passe-haut en deux canaux, avec une ligne à retard de phase en temps réel disposée dans l'un desdits canaux.

6. Convertisseur selon la revendication 5, **caractérisé en ce que** ladite unité de traitement de signal numérique comprend une transformée de Fourier rapide pour le traitement desdits signaux numériques, suivie d'un traitement algorithmique pour la détection croisée et l'association de fréquences originales et modulées et l'extraction de caractéristiques précises et temporelles du signal.

7. Convertisseur numérique analogique-information d'un signal RF, ledit convertisseur comprenant:

   a. un séparateur configuré pour diviser le signal filtré passe-haut en deux canaux, suivi de
   b. un premier numériseur et un second numériseur, configurés pour échantillonner les signaux obtenus à deux fréquences d'échantillonnage spécifiquement accordées;
   c. une unité de traitement de signal numérique;

**caractérisé en ce que** ladite unité de traitement de signal numérique est configurée pour un traitement de générateur Doppler numérique à des fréquences d'échantillonnage prédéterminées, une procédure de décimation, une transformation de Fourier rapide et une normalisation prédéterminée du spectre de fréquence.

8. Convertisseur numérique analogique-information selon la revendication 7, dans lequel une relation entre les fréquences d'échantillonnage auxdits premier et second numériseurs est donnée par:

$$f_2 = f_1 \cdot \left(1 + K\right)^{-1} = f_1 \cdot \frac{c}{c + v}$$

où v est la vitesse Doppler souhaitée, c'est la vitesse de la lumière, K est le taux de compression et $f_1$, $f_2$ sont les fréquences d'échantillonnage.

9. Convertisseur numérique analogique-information selon la revendication 7, **caractérisé en ce que** ladite unité de traitement de signal numérique est configurée pour décimer le signal $Y_1$ numérisé par ledit premier numériseur à longueur égale au signal $Y_2$ numérisé par ledit second numériseur, leur procéder à un transformée de Fourier rapide $(F(Y_1)F(Y_2))$, et normalisation du spectre de fréquences de $Y_2$ par la relation suivante: $F(Y_2)*(1+K)$.

10. Convertisseur selon la revendication 7 configuré pour au moins une application sélectionnée dans le groupe constitué de;

    e. Spectre en temps réel de bande passante ultra large;
    f. Détection et gestion du spectre pour la radio cognitive;
    g. Identification et cartographie des émetteurs pour les systèmes ESM; et
    h. Systèmes RWR à très large bande passante.

High-pass filtering — 210

Splitting — 220

Phase true-time delay shifting — 230

← 200

Mixing — 240

Low-pass filtering — 250

Analog-digital converting — 260

Digital signal processing — 270

Fig.1

Fig.2

14

100

$F$                $F$

| 10 | | 30 | | 50 |

| 20 | | 40 |

$F + f_{\mathrm{d}}$

# Fig. 3

# Fig. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20110149791 A
- GB 2189631 A
- US 3855423 A
- US 20080024336 A

**Non-patent literature cited in the description**

- Wei-Chieh Huang. IEEE, 03 September 2012, 1-5